# EUROPEAN PATENT APPLICATION

(11) **EP 1 458 034 A2**
(43) Date of publication of application: **15.09.2004**
(21) Application number: 04251457.0
(22) Date of filing: 12.03.2004
(51) Int. Cl.: H01L 31/0224, H01L 31/075, H01L 31/20

(54) **Photovoltaic device and device having transparent conductive film**

(30) Priority: 14.03.2003 JP 2003069007
(71) Applicant: Sanyo Electric Co., Ltd., Moriguchi-shi, Osaka-fu 570-8677 (JP)
(72) Inventor: Maruyama, Eiji, Katano-shi, Osaka 576-0021 (JP)
(74) Representative: Calderbank, Thomas Roger

(57) **Abstract**

A photovoltaic device comprising a transparent conductive film compatibly attaining low resistance and low light absorption loss is provided. This photovoltaic device comprises a photoelectric conversion layer receiving light on the front surface side and a transparent conductive film, formed on the front surface of the photoelectric conversion film, including an indium oxide layer having (222) plane orientation with two (222) peaks in the indium oxide layer.

## Description

The present invention relates to a photovoltaic device and a device having a transparent conductive film, and more particularly, it relates to a photovoltaic device comprising a transparent conductive film consisting of an indium oxide layer and a device having a transparent conductive film.

A device having a transparent conductive film such as a photovoltaic device comprising a transparent conductive film consisting of an indium oxide layer is known in general. For example, Japanese Patent Laying-Open No. 5-136440 (1993) discloses a device such as a photovoltaic device having a transparent conductive film.

The aforementioned Japanese Patent Laying-Open No. 5-136440 discloses a photovoltaic device comprising a transparent conductive film consisting of an indium tin oxide (ITO) layer containing Sn as a dopant. The following description is made with reference to a photovoltaic device employed as an exemplary device having a transparent conductive film.

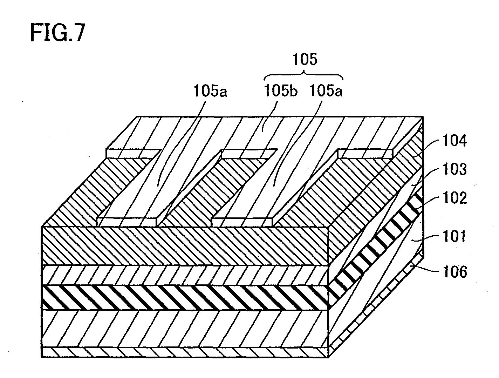

Fig. 7 is a perspective view showing the structure of an exemplary conventional photovoltaic device comprising a transparent conductive film. Referring to Fig. 7, a substantially intrinsic i-type amorphous silicon layer 102, a p-type amorphous silicon layer 103, a transparent conductive film 104 consisting of ITO and a collector 105 consisting of a metal are successively formed on the upper surface of an n-type single-crystalline silicon substrate 101. The collector 105 is constituted of a plurality of finger electrode parts 105a formed to extend in parallel with each other at a prescribed interval and a bus bar electrode part 105b aggregating currents flowing in the finger electrode parts 105a. A back electrode 106 is formed on the back surface of the n-type single-crystalline silicon substrate 101. The n-type single-crystalline silicon substrate 101, the i-type amorphous silicon layer 102 and the p-type amorphous silicon layer 103 are stacked in this order thereby forming an HIT (heterojunction with intrinsic thin-layer) structure.

It is known that the transparent conductive film 104 of the conventional photovoltaic device shown in Fig. 7 must have low resistance and low light absorption loss in order to effectively improve the energy conversion efficiency of the photovoltaic device.

In general, however, no constitution of such a transparent conductive film for compatibly attaining low resistance and low light absorption loss is sufficiently studied and hence it is disadvantageously difficult to obtain a photovoltaic device comprising a transparent conductive film compatibly attaining low resistance and low light absorption loss.

The present invention has been proposed in order to solve the aforementioned problem, and an object of the present invention is to provide a photovoltaic device comprising a transparent conductive film compatibly attaining low resistance and low light absorption loss.

Another object of the present invention is to provide a device comprising a transparent conductive film compatibly attaining low resistance and low light absorption loss.

In order to attain the aforementioned objects, a photovoltaic device according to a first aspect of the present invention comprises a photoelectric conversion layer receiving light incident from the front surface side and a transparent conductive film, formed on the front surface of the photoelectric conversion layer, including an indium oxide layer having (222) plane orientation with two (222) peaks in the indium oxide layer.

In the photovoltaic device according to the first aspect, as hereinabove described, the transparent conductive film is so formed as to include the indium oxide layer having (222) plane orientation with two (222) peaks in the indium oxide layer so that the resistance of the transparent conductive film can be reduced, whereby the photovoltaic device can be inhibited from reduction of the fill factor (F.F.). The transparent conductive film is formed in the aforementioned manner so that the light absorption loss thereof can be reduced, whereby the short-circuit current (Isc) of the photovoltaic device can be increased. Further, the resistance and the light absorption loss of the transparent conductive film can be simultaneously reduced, whereby the photovoltaic device comprising the transparent conductive film can compatibly attain low resistance and low light absorption loss.

The aforementioned photovoltaic device according to the first aspect preferably further comprises a semiconductor layer, formed thereon with the transparent conductive film, consisting of at least either an amorphous semiconductor or a microcrystalline semiconductor. According to this structure, the resistance and the light absorption loss of the transparent conductive film can be simultaneously reduced in the photovoltaic device comprising the semiconductor layer, formed thereon with the transparent conductive film, consisting of at least either an amorphous semiconductor or a microcrystalline semiconductor.

In the aforementioned photovoltaic device according to the first aspect, the (222) peaks in the indium oxide layer preferably include a first peak having an angle 2θ (θ: X-ray diffraction angle) of 30.1 ± 0.1 degrees and a second peak having an angle 2θ (θ: X-ray diffraction angle) of 30.6 ± 0.1 degrees. According to this structure, the resistance and the light absorption loss of the transparent conductive film can be easily reduced at the same time.

In this case, the ratio (I1/I2) of the intensity (I1) of the first peak to the intensity (I2) of the second peak is preferably at least 0.07 and not more than 0.9. According to this structure, the output of the photovoltaic device can be easily improved. In this case, the ratio (I1/I2) of the intensity (I1) of the first peak to the intensity (I2) of the second peak is more preferably at least 0.25 and not more than 0.75. According to this structure, the output of the photovoltaic device can be further improved.

In the aforementioned photovoltaic device according to the first aspect, the indium oxide layer preferably contains Sn. According to this structure, the resistance and the light absorption loss of the transparent conductive film can be simultaneously reduced in the photovoltaic device comprising the transparent conductive film consisting of the indium oxide layer (ITO film) containing Sn.

In this case, the content of Sn with respect to In in the indium oxide layer may be at least 1 percent by weight and not more than 10 percent by weight.

A photovoltaic device according to a second aspect of the present invention comprises a first conductivity type crystalline semiconductor substrate having a front surface and a back surface and receiving light incident from the side of the front surface, a substantially intrinsic first amorphous semiconductor layer formed on the front surface of the crystalline semiconductor substrate, a second conductivity type second amorphous semiconductor layer formed on the first amorphous semiconductor layer and a transparent conductive film, formed on the second amorphous semiconductor layer, including an indium oxide layer having (222) plane orientation with two (222) peaks in the indium oxide layer.

In the photovoltaic device according to the second aspect, as hereinabove described, the transparent conductive film is so formed as to include the indium oxide layer having (222) plane orientation with two (222) peaks in the indium oxide layer so that the resistance of the transparent conductive film can be reduced, whereby the photovoltaic device can be inhibited from reduction of the fill factor (F.F.). The transparent conductive film is formed in the aforementioned manner so that the light absorption loss thereof can be reduced, whereby the short-circuit current (Isc) of the photovoltaic device can be increased. Further, the substantially intrinsic first amorphous semiconductor layer and the second conductivity type second amorphous semiconductor layer are formed on the front surface of the first conductivity type crystalline semiconductor substrate in this order, so that the photovoltaic device can be provided with an HIT structure on the front surface thereof. Consequently, the HIT-structure photovoltaic device comprising the transparent conductive film can compatibly attain low resistance and low light absorption loss.

In the aforementioned photovoltaic device according to the second aspect, the (222) peaks in the indium oxide layer preferably include a first peak having an angle 2θ (θ: X-ray diffraction angle) of 30.1 ± 0.1 degrees and a second peak having an angle 2θ (θ: X-ray diffraction angle) of 30.6 ± 0.1 degrees. According to this structure, the resistance and the light absorption loss of the transparent conductive film can be easily reduced at the same time.

In this case, the ratio (I1/I2) of the intensity (I1) of the first peak to the intensity (I2) of the second peak is preferably at least 0.07 and not more than 0.9. According to this structure, the output of the photovoltaic device can be easily improved. In this case, the ratio (I1/I2) of the intensity (I1) of the first peak to the intensity (12) of the second peak is more preferably at least 0.25 and not more than 0.75. According to this structure, the output of the photovoltaic device can be further improved.

In the aforementioned photovoltaic device according to the second aspect, the indium oxide layer preferably contains Sn. According to this structure, the resistance and the light absorption loss of the transparent conductive film can be simultaneously reduced in the photovoltaic device comprising the transparent conductive film consisting of the indium oxide layer (ITO film) containing Sn.

In this case, the content of Sn with respect to In in the indium oxide layer may be at least 1 percent by weight and not more than 10 percent by weight.

In the aforementioned photovoltaic device according to the second aspect, the crystalline semiconductor substrate is preferably an n-type semiconductor substrate, and the second amorphous semiconductor layer is preferably a p-type semiconductor layer. According to this structure, the transparent conductive film can compatibly attain low resistance and low light absorption loss in the photovoltaic device having the substantially intrinsic first amorphous semiconductor layer, the p-type second amorphous semiconductor layer and the transparent conductive film successively formed on the light-receiving side surface of the n-type crystalline semiconductor substrate.

A device having a transparent conductive film according to a third aspect of the present invention comprises a substrate and a transparent conductive film, formed on the substrate, including an indium oxide layer having (222) plane orientation with two (222) peaks in the indium oxide layer.

In the device having a transparent conductive film according to the third aspect, as hereinabove described, the transparent conductive film is so formed as to include the indium oxide layer having (222) plane orientation with two (222) peaks in the indium oxide layer so that the resistance and the light absorption loss of the transparent conductive film can be reduced at the same time. Thus, the transparent conductive film of the device can compatibly attain low resistance and low light absorption loss.

In the aforementioned device having a transparent conductive film according to the third aspect, the (222) peaks in the indium oxide layer preferably include a first peak having an angle 2θ (θ: X-ray diffraction angle) of 30.1 ± 0.1 degrees and a second peak having an angle 2θ (θ: X-ray diffraction angle) of 30.6 ± 0.1 degrees. According to this structure, the resistance and the light absorption loss of the transparent conductive film can be easily reduced at the same time.

In the aforementioned device having a transparent conductive film according to the third aspect, the indium oxide layer preferably contains Sn. According to this structure, the resistance and the light absorption loss of the transparent conductive film can be simultaneously reduced in the device having the transparent conductive film consisting of the indium oxide layer (ITO film) containing Sn.

In this case, the content of Sn with respect to In in the indium oxide layer may be at least 1 percent by weight and not more than 10 percent by weight.

A photovoltaic device according to a fourth aspect of the present invention comprises a first conductivity type single-crystalline silicon substrate having a front surface and a back surface and receiving light on the side of the front surface, a substantially intrinsic first amorphous silicon layer formed on the front surface of the single-crystalline silicon substrate, a second conductivity type second amorphous silicon layer formed on the first amorphous silicon layer and a transparent conductive film, formed on the second amorphous silicon layer, including an indium oxide layer having (222) plane orientation with two (222) peaks in the indium oxide layer.

In the photovoltaic device according to the fourth aspect, as hereinabove described, the transparent conductive film is so formed as to include the indium oxide layer having (222) plane orientation with two (222) peaks in the indium oxide layer so that the resistance of the transparent conductive film can be reduced, whereby the photovoltaic device can be inhibited from reduction of the fill factor (F.F.). The transparent conductive film is formed in the aforementioned manner so that the light absorption loss thereof can be reduced, whereby the short-circuit current (Isc) of the photovoltaic device can be increased. Further, the substantially intrinsic first amorphous silicon layer and the second conductivity type second amorphous silicon layer are formed on the front surface of the first conductivity type single-crystalline silicon substrate in this order, whereby the photovoltaic device can be provided with an HIT structure on the front surface thereof. Consequently, the HIT-structure photovoltaic device comprising the transparent conductive film can compatibly attain low resistance and low light absorption loss.

In the aforementioned photovoltaic device according to the fourth aspect, the (222) peaks in the indium oxide layer preferably include a first peak having an angle 2θ (θ: X-ray diffraction angle) of 30.1 ± 0.1 degrees and a second peak having an angle 2θ (θ: X-ray diffraction angle) of 30.6 ± 0.1 degrees. According to this structure, the resistance and the light absorption loss of the transparent conductive film can be easily reduced at the same time.

The foregoing and other objects, features, aspects and advantages of the present invention will become more apparent from the following detailed description of the present invention when taken in conjunction with the accompanying drawings.
In the drawings:
Fig. 1 is a perspective view showing the structure of a photovoltaic device according to an embodiment of the present invention;
Fig. 2 illustrates an X-ray diffraction spectrum measured in a transparent conductive film (ITO film) of a photovoltaic device air-dried at 200°C for 80 minutes;
Fig. 3 is an enlarged view of a portion around (222) peaks of the X-ray diffraction spectrum shown in Fig. 2;
Fig. 4 is a correlation diagram showing the relation between normalized oxygen flow rates and the peak intensity ratios (I1/I2) between the intensity levels of first and second peaks P1 and P2 with reference to transparent conductive films (ITO films) formed at various oxygen flow rates;
Fig. 5 is a correlation diagram showing the relation between the strength of magnetic fields applied to a cathode and the peak intensity ratios (I1/I2) with reference to transparent conductive films (ITO films) formed with various magnetic fields applied to a cathode in the range of 500 G to 3000 G;
Fig. 6 is a correlation diagram showing the relation between the peak intensity ratios (I1/I2) corresponding to those shown in Fig. 4 and normalized values of IV characteristic parameters (open-circuit voltages (Voc), short-circuit currents (Isc), fill factors (F.F.) and cell outputs (Pmax)) of photovoltaic devices; and
Fig. 7 is a perspective view showing the structure of an exemplary conventional photovoltaic device comprising a transparent conductive film.

An embodiment of the present invention is now described with reference to the drawings.

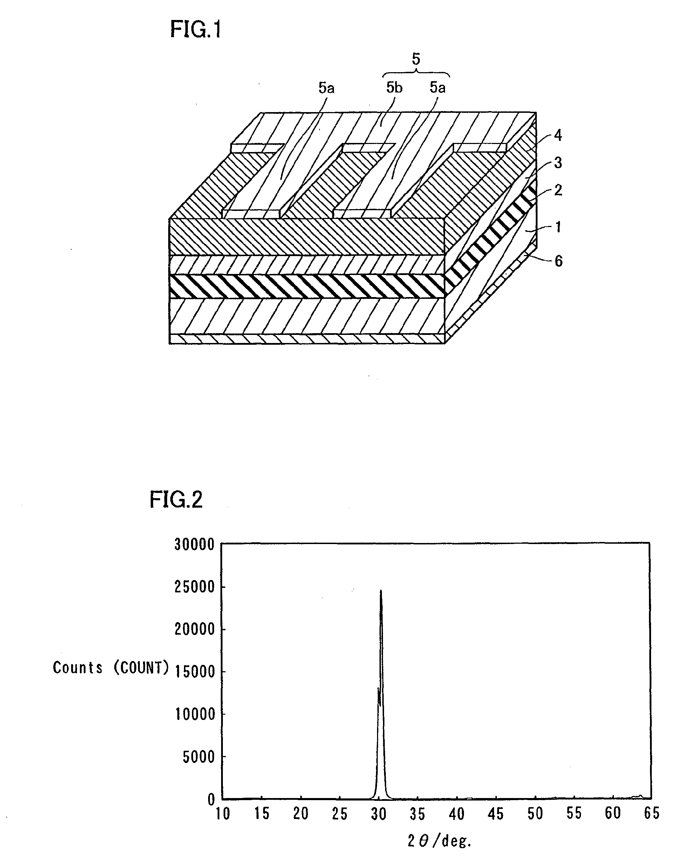

First, the structure of a photovoltaic device according to this embodiment is described with reference to Fig. 1. In the photovoltaic device according to this embodiment, a substantially intrinsic i-type amorphous silicon layer 2 having a thickness of about 5 nm is formed on the upper surface of an n-type (100) single-crystalline silicon substrate (hereinafter referred to as an n-type single-crystalline silicon substrate) 1 having resistivity of about 1 Ω·cm and a thickness of about 300 µm. A p-type amorphous silicon layer 3 having a thickness of about 5 nm is formed on the i-type amorphous silicon layer 2. Thus, an HIT structure is formed on the front surface of the photovoltaic device according to this embodiment. The n-type single-crystalline silicon substrate 1 is an example of the "photoelectric conversion layer", the "crystalline semiconductor substrate", the "substrate" or the "single-crystalline silicon substrate" in the present invention. The i-type amorphous silicon layer 2 is an example of the "first amorphous semiconductor layer" or the "first amorphous silicon layer" in the present invention. The p-type amorphous silicon layer 3 is an example of the "second amorphous semiconductor layer" or the "second amorphous silicon layer" in the present invention.

According to this embodiment, a transparent conductive film 4 consisting of an ITO film having a thickness of about 100 nm is formed on the p-type amorphous silicon layer 3. This transparent conductive film 4 is formed by the ITO film including two (222) peaks, i.e., a first peak having an angle 2θ (θ: X-ray diffraction angle) of about 30.1 ± 0.1 degrees and a second peak having an angle 2θ (θ: X-ray diffraction angle) of about 30.6 ± 0.1 degrees, in an X-ray diffraction spectrum. The ratio (I1/I2) of the intensity (I1) of the first peak to the intensity (I2) of the second peak is set to at least about 0.07 and not more than about 0.9.

A collector 5 of silver (Ag) having a thickness of about 10 µm to about 30 µm is formed on a prescribed region of the upper surface of the transparent conductive film 4. This collector 5 is constituted of a plurality of finger electrode parts 5a formed to extend in parallel with each other at a prescribed interval and a bus bar electrode part 5b aggregating currents flowing in the finger electrode parts 5a. A back electrode 6 of silver (Ag) having a thickness of about 10 µm to about 30 µm is formed on the back surface of the n-type single-crystalline silicon substrate 1.

A process of fabricating the photovoltaic device according to this embodiment is now described with reference to Fig. 1. First, the n-type single-crystalline silicon substrate 1 having the resistivity of about 1 Ω·cm and the thickness of about 300 µm is cleaned thereby removing impurities. The i-type amorphous silicon layer 2 and the p-type amorphous silicon layer 3 are successively deposited on the n-type single-crystalline silicon substrate 1 with the thicknesses of about 5 nm respectively under conditions of a frequency of about 13.56 MHz, a formation temperature of about 100°C to about 300°C, a reaction pressure of about 5 Pa to about 100 Pa and RF power of about 1 mW/cm² to about 500 mW/cm², thereby forming a p-i-n junction. A group III element such as B, A1, Ga or In can be employed as the p-type dopant for forming the p-type amorphous silicon layer 3. The p-type amorphous silicon layer 3 can be formed by mixing compound gas containing at least one of the aforementioned p-type dopants into material gas such as SiH₄ (silane) gas.

Then, the transparent conductive film 4 consisting of the ITO film is formed on the p-type amorphous silicon layer 3 by sputtering (DC sputtering). More specifically, a target consisting of a sintered body of In₂O₃ powder containing about 5 percent by weight of SnO₂ powder is set on a cathode (not shown) in a chamber (not shown). The Sn content in the ITO film can be varied by changing the quantity of the SnO₂ powder. The content of Sn with respect to In is preferably about 1 percent by weight to about 10 percent by weight, and more preferably about 2 percent by weight to about 7 percent by weight. The sintering density of the target is preferably at least about 90 %. The transparent conductive film 4 is formed by an apparatus capable of applying a strong magnetic field of about 500 G to about 3000 G to the surface of the cathode with a magnet, in order to suppress plasma damage applied to the p-type amorphous silicon layer 3 serving as the underlayer for the transparent conductive film 4.

The chamber (not shown) is evacuated while oppositely arranging the n-type single-crystalline silicon substrate 1 formed with the p-type amorphous silicon layer 3 in parallel with the cathode. The substrate temperature is controlled in the range of the room temperature to about 100°C with a heater (not shown). Thereafter a gas mixture of Ar and O₂ is fed for holding the pressure to about 0.4 Pa to about 1.3 Pa, and power of about 0.5 kW to about 2 kW is applied to the cathode for starting discharge while controlling the substrate temperature in the range of the room temperature to about 100°C. In this case, a film forming rate is about 10 nm/min. to about 80 nm/min. while the n-type single-crystalline silicon substrate 1 is stood still with respect to the cathode. The transparent conductive film 4 consisting of the ITO film is formed with the thickness of about 100 nm in the aforementioned manner, and the discharge is thereafter stopped.

Then, Ag paste prepared by kneading impalpable silver (Ag) powder into epoxy resin is applied to the prescribed region of the upper surface of the transparent conductive film 4 by screen printing to have a thickness of about 10 µm to about 30 µm and a width of about 100 µm to about 500 µm and thereafter fired at about 200°C for 80 minutes to be hardened, thereby forming the collector 5 consisting of the plurality of finger electrode parts 5a formed to extend in parallel with each other at the prescribed interval and the bus bar electrode part 5b aggregating the currents flowing in the finger electrode parts 5a. Thus, the photovoltaic device according to this embodiment is formed as shown in Fig. 1.

In order to confirm the effects of the aforementioned embodiment, an experiment was made by measuring the X-ray diffraction spectrum of a transparent conductive film and the I-V characteristics of a photovoltaic device comprising the transparent conductive film. First, a target consisting of a sintered body of In₂O₃ powder containing 5 percent by weight of SnO₂ powder was employed for preparing a photovoltaic device having a transparent conductive film (ITO film) of about 100 nm in thickness formed on a p-type amorphous silicon layer by DC sputtering. Other forming conditions for the transparent conductive film were a substrate temperature of 60°C, an Ar flow rate of 200 sccm, an oxygen flow rate of 0 to 20 sccm, a pressure of 0.5 Pa, DC power of 1 kW and a magnetic field of 1000 G to 3000 G applied to a cathode. The structures of the remaining portions of the photovoltaic device other than the transparent conductive film and a process of fabricating the same were similar to those of the photovoltaic device according to the aforementioned embodiment. In order to excellently detect a signal of the X-ray diffraction spectrum, an n-type single-crystalline silicon substrate having a relatively flat front surface was employed. As to the transparent conductive film of the photovoltaic device prepared in the aforementioned manner, the X-ray diffraction spectrum was measured with an X-ray analyzer thereby evaluating the crystal orientation of the transparent conductive film (ITO film).

The X-ray diffraction spectrum was measured before and after a step of air-drying the aforementioned photovoltaic device at 200°C for 80 minutes respectively. The air-drying conditions of 200°C and 80 minutes correspond to the conditions for forming the aforementioned collector 5. Before the air-drying step, the ITO film exhibited an X-ray diffraction spectrum (not shown) specific to a film containing a large quantity of amorphous components. On the other hand, the air-dried ITO film exhibited clear peaks as shown in Fig. 2, to prove that crystallization of the ITO film was remarkably prompted. It is understood that this X-ray diffraction spectrum exhibits the maximum intensity (the maximum count by a detector of the X-ray analyzer) at (222) peaks. Thus, it has been proved that the transparent conductive film of this photovoltaic device consisted of the ITO film having extremely strong (222) orientation.

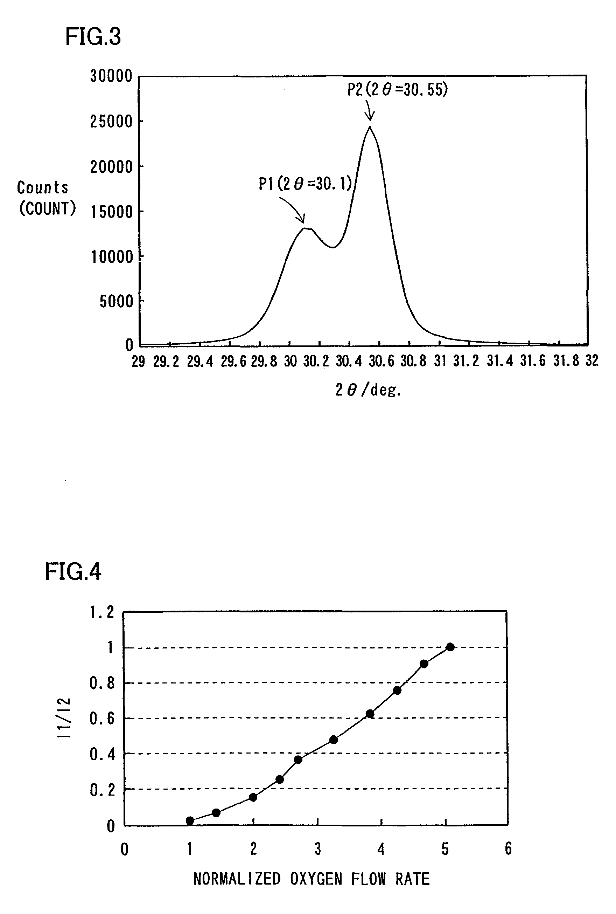

Referring to Fig. 3, it is understood that the transparent conductive film has two (222) peaks P1 and P2 having angles 2θ (θ: X-ray diffraction angle) of 30.1 degrees and 30.55 degrees respectively. It is known that a general ITO film exhibits a peak, corresponding to the peak P2, having an angle 2θ of around 30.55 degrees. On the other hand, a peak, corresponding to the peak P1, having an angle 2θ of around 30.1 degrees is not frequently observed. Thus, it is understood that the ITO film forming the transparent conductive film according to this embodiment contains crystals of ITO having a slightly larger lattice constant than a conventional one. The peaks P1 and P2 having angles 2θ of 30.1 ± 0.1 degrees and 30.6 ± 0.1 degrees are hereinafter referred to as first and second peaks respectively.

Fig. 4 shows the relation between normalized oxygen flow rates and the peak intensity ratios (I1/I2) between the peak intensity levels of first and second peaks P1 and P2 with reference to transparent conductive films (ITO films) prepared from targets consisting of sintered bodies of In₂O₃ powder containing 5 percent by weight of SnO₂ powder by DC sputtering at various oxygen flow rates. At this time, the transparent conductive films were prepared under conditions of a substrate temperature of 60°C, an Ar flow rate of 200 sccm, a pressure of 0.5 Pa, DC power of 1 kW and a magnetic field of 2000 G applied to a cathode. Counts of the first and second peaks P1 and P2 detected by a detector of an X-ray analyzer were employed as the peak intensity levels I1 and I2 of the first and second peaks P1 and P2 respectively. Fig. 4 shows oxygen flow rates normalized with reference to an oxygen flow rate of 4 sccm minimizing the sheet resistance of the transparent conductive films. Referring to Fig. 4, it is understood that the peak intensity ratios (I1/I2) increase in proportion to the normalized oxygen flow rates. Thus, it is understood that the peak intensity ratio (I1/I2) of a transparent conductive film can be controlled by controlling the oxygen flow rate for forming the transparent conductive film.

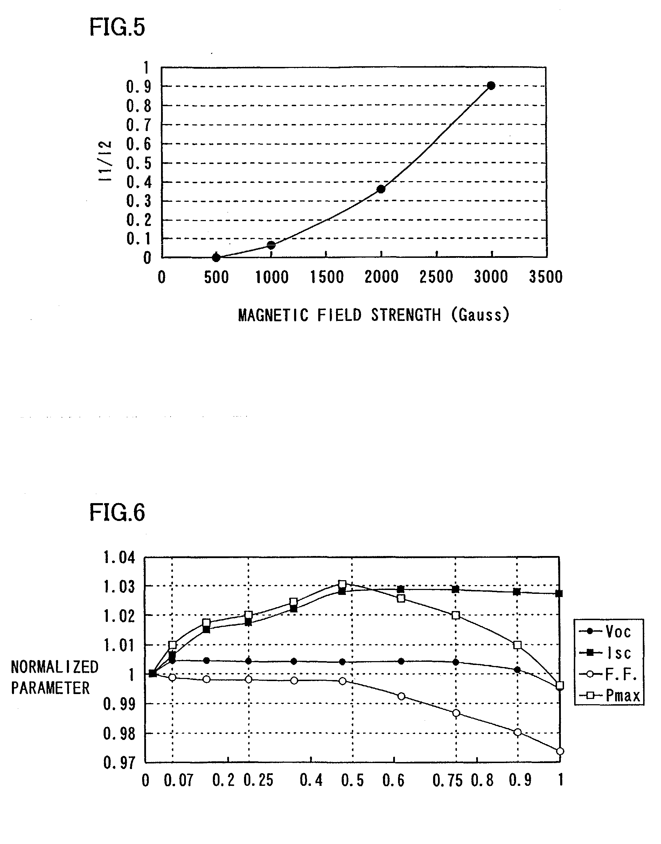

Fig. 5 shows the relation between the strength of magnetic fields applied to a cathode and the peak intensity ratios (I1/I2) with reference to transparent conductive films (ITO films) prepared from targets consisting of sintered bodies of In₂O₃ powder containing 5 percent by weight of SnO₂ powder by DC sputtering while applying various magnetic fields to the cathode in the range of 500 G to 3000 G. At this time, the transparent conductive films were prepared under conditions of a substrate temperature of 60°C, an Ar flow rate of 200 seem, a normalized oxygen flow rate of about 2.7 (oxygen flow rate: about 10.8 sccm), a pressure of 0.5 Pa and DC power of 1 kW. Referring to Fig. 5, it is understood that the peak intensity ratios (I1/I2) increase in proportion to the magnetic field strength. Thus, it is understood that the peak intensity ratio (I1/I2) of a transparent conductive film can be controlled by controlling the strength of a magnetic field applied to a cathode for forming the transparent conductive film.

Results of evaluation of the relation between the peak intensity ratios (I1/I2) of transparent conductive films of photovoltaic devices and IV characteristic parameters (open-circuit voltages (Voc), short-circuit currents (Isc), fill factors (F.F.) and cell outputs (Pmax)) of the photovoltaic devices are described. Fig. 6 shows the relation between the peak intensity ratios (I1/I2) corresponding to those shown in Fig. 4 and normalized values of the IV characteristic parameters (open-circuit voltages (Voc), short-circuit currents (Isc), fill factors (F.F.) and cell outputs (Pmax)) of the photovoltaic devices. Referring to Fig. 6, the IV characteristic parameters were normalized as to the photovoltaic devices prepared by forming transparent conductive films under conditions of a substrate temperature of 60°C and a magnetic field of 2000 G applied to a cathode at an oxygen flow rate (4 sccm) minimizing the sheet resistance of the transparent conductive films. In other words, the IV characteristics of the photovoltaic devices formed at the normalized oxygen flow rate of 1 (oxygen flow rate: 4 sccm) in Fig. 4 were normalized.

Referring to Fig. 6, it is understood that the fill factor (F.F.) is hardly reduced when the peak intensity ratio (I1/I2) is not more than 0.5. It is also understood that the fill factor (F.F.) tends to be slightly reduced when the peak intensity ratio (I1/I2) exceeds 0.5. However, this degree of reduction of the fill factor (F.F.) is extremely small as compared with the degree of reduction of the fill factor (F.F.) in a conventional photovoltaic device employing a transparent conductive film whose light absorption loss can be further reduced. The fill factor (F.F.) is correlated with the resistance of the transparent conductive film of the photovoltaic device. In other words, the fill factor (F.F.) is correlatively reduced when the resistance of the transparent conductive film of the photovoltaic device is increased. The degree of reduction of the fill factor (F.F.) in the transparent conductive film of the photovoltaic device according to this embodiment is extremely smaller than that in the conventional photovoltaic device, and hence it is understood that this increase of the resistance of the transparent conductive film is extremely smaller than that in the prior art. Thus, it is understood that the resistance of the transparent conductive film is reduced as compared with the prior art in the photovoltaic device according to this embodiment. Referring to Fig. 6, the fill factors (F.F.) exhibit a tendency of slight reduction conceivably due to slight increase of the resistance of the transparent conductive films and reduction of ohmic properties on the interfaces between p-type amorphous silicon substrates and the transparent conductive films.

It is also understood from Fig. 6 that the open-circuit voltage (Voc) is maintained at a value of at least 1 when the peak intensity ratio (I1/I2) is in the range of not more than 0.9. Thus, it is understood that the photovoltaic device according to this embodiment can keep the open-circuit voltage (Voc) unreduced. This result was obtained conceivably for the following reason: Plasma damage applied to a p-type amorphous silicon layer serving as the underlayer for the transparent conductive film was suppressed also under a high oxygen flow rate condition due to a high magnetic field applied to the cathode under a substrate temperature condition lower than that in the prior art. Thus, the open-circuit voltage (Voc) can conceivably kept unreduced.

It is further understood from Fig. 6 that the short-circuit current (Isc) is increased in proportion to the peak intensity ratio (I1/I2) when the peak intensity ratio (I1/I2) is in the range of not more than 0.5 while the short-circuit current (Isc) is saturated at a substantially constant value when the peak intensity ratio (I1/I2) exceeds 0.5. The short-circuit current (Isc) is correlated with the light absorption loss of the transparent conductive film of the photovoltaic device. More specifically, the short-circuit current (Isc) is correlatively increased when the light absorption loss of the transparent conductive film of the photovoltaic device is reduced. Thus, it is understood that the light absorption loss of the transparent conductive film is reduced as the peak intensity ratio (I1/I2) is increased when the peak intensity ratio (I1/I2) is in the range of not more than 0.5 while reduction of the light absorption loss is stopped and the light absorption loss is stabilized at a substantially constant value when the peak intensity ratio (I1/I2) exceeds 0.5 in the photovoltaic device according to this embodiment. Thus, it is understood that the light absorption loss of the transparent conductive film is reduced in the photovoltaic device according to this embodiment.

It is also understood from Fig. 6 that the cell output (Pmax) is increased in proportion to the peak intensity ratio (I1/I2) when the peak intensity ratio (I1/I2) is in the range of up to 0.5, maximized when the peak intensity ratio (I1/I2) is around 0.5, and reduced when the peak intensity ratio (I1/I2) exceeds 0.5. It is known that the cell output (Pmax) is increased in proportion to the fill factor (F.F.) and the short-circuit current (Isc). When the peak intensity ratio (I1/I2) is in the range of up to 0.5, the fill factor (F.F.) is hardly reduced and the short-circuit current (Isc) is increased in proportion to the peak intensity ratio (I1/I2), as shown in Fig. 6. Therefore, the cell output (Pmax) is increased in proportion to the peak intensity ratio (I1/I2) when the peak intensity ratio (I1/I2) is in the range of up to 0.5 conceivably due to the increase of the short-circuit current (Isc). Further, the fill factor (F.F.) is hardly reduced and the short-circuit current (Isc) is saturated at the substantially constant value when the peak intensity ratio (I1/I2) is around 0.5, and hence the cell output (Pmax) is conceivably maximized at this time. When the peak intensity ratio (I1/I2) exceeds 0.5, the fill factor (F.F.) is reduced and the short-circuit current (Isc) is saturated at the substantially constant value. Therefore, the reduction of the cell output (Pmax) following the increase of the peak intensity ratio (I1/I2) exceeding 0.5 conceivably results from reduction of the fill factor (F.F.).

It is further understood that the cell output (Pmax) exhibits a value of at least 1.01 when the peak intensity ratio (I1/I2) is in the range of at least 0.07 and not more than 0.9 and that the cell output (Pmax) exhibits a value of at least 1.02 when the peak intensity ratio (I1/I2) is in the range of at least 0.25 and not more than 0.75. Thus, it is understood that the cell output (Pmax) of the photovoltaic device can be improved by at least 1 % as compared with a case where the sheet resistance of the transparent conductive film is minimized when the peak intensity ratio (I1/I2) of the transparent conductive film (ITO film) is in the range of at least 0.07 and not more than 0.9. It is also understood that the cell output (Pmax) of the photovoltaic device can be improved by at least 2 % as compared with the case where the sheet resistance of the transparent conductive film is minimized when the peak intensity ratio (I1/I2) of the transparent conductive film (ITO film) is in the range of at least 0.25 and not more than 0.75.

According to this embodiment, as hereinabove described, the transparent conductive film 4 is so formed as to include the ITO film having (222) plane orientation with the two (222) peaks, i.e., the first and second peaks P1 and P2 having the angles 2θ of 30.1 ± 0.1 degrees and 30.6 ± 0.1 degrees respectively so that the resistance of the transparent conductive film 4 can be reduced, whereby the photovoltaic device can be inhibited from reduction of the fill factor (F.F.). Further, the transparent conductive film 4 is formed in the aforementioned manner so that the light absorption loss thereof can be reduced, whereby the short-circuit current (Isc) of the photovoltaic device can be increased. In addition, the resistance and the light absorption loss of the transparent conductive film 4 can be simultaneously reduced, whereby the photovoltaic device comprising the transparent conductive film 4 can compatibly attain low resistance and low light absorption loss.

Although the present invention has been described and illustrated in detail, it is clearly understood that the same is by way of illustration and example only and is not to be taken by way of limitation, the spirit and scope of the present invention being limited only by the terms of the appended claims.

For example, while the above embodiment has been described with reference to the case of employing a photoelectric conversion layer consisting of the n-type single-crystalline silicon substrate 1, the present invention is not restricted to this but similar effects can be attained also when employing a photoelectric conversion layer consisting of a p-type single-crystalline silicon substrate or an amorphous silicon layer.

While the present invention is applied to the photovoltaic device having the HIT structure prepared by successively forming the substantially intrinsic i-type amorphous silicon layer 2 and the p-type amorphous silicon layer 3 on the n-type single-crystalline silicon substrate 1 in the aforementioned embodiment, the present invention is not restricted to this but is also applicable to a photovoltaic device having no HIT structure, for attaining similar effects.

While the above embodiment has been described with reference to the photovoltaic device employed as an exemplary device having a transparent conductive film, the present invention is not restricted to this but is also applicable to a device having a transparent conductive film other than the photovoltaic device. For example, the present invention is applicable to a light-emitting device employed for an image display or the like. In this case, the present invention is preferably applied to a transparent conductive film provided on a light-emitting side.

While the aforementioned embodiment employs silicon (Si) as a semiconductor material, the present invention is not restricted to this but any semiconductor material selected from SiGe, SiGeC, SiC, SiN, SiGeN, SiSn, SiSnN, SiSnO, SiO, Ge, GeC and GeN may alternatively be employed. In this case, the selected semiconductor material may be a crystalline material or an amorphous or microcrystalline material containing at least either hydrogen or fluorine.

While the above embodiment has been described with reference to the case of forming the transparent conductive film 4 on the amorphous silicon layer 3, the present invention is not restricted to this but the inventor has experimentally confirmed that similar effects can be attained also when the transparent conductive film according to the present invention is formed on a microcrystalline silicon layer, an amorphous SiC layer or an amorphous SiO layer.

While the i-type amorphous silicon layer 2 and the p-type amorphous silicon layer 3 are formed by RF plasma CVD in the aforementioned embodiment, the present invention is not restricted to this but the amorphous silicon layers 2 and 3 may alternatively be formed by another method such as evaporation, sputtering, microwave plasma CVD, ECR, thermal CVD or LPCVD (low-pressure CVD).

While the indium oxide (ITO) film doped with Sn is employed as the material for constituting the transparent conductive film 4 in the aforementioned embodiment, the present invention is not restricted to this but the transparent conductive film 4 may alternatively consist of a material, other than the ITO film, prepared from indium oxide doped with a material other than Sn. For example, the transparent conductive film 4 may alternatively be formed by a target prepared by mixing a proper quantity of at least one of Zn, As, Ca, Cu, F, Ge, Mg, S, Si and Te into indium oxide powder (In₂O₃) as compound powder and sintering the mixture.

While Ar gas is employed for sputtering the ITO film constituting the transparent conductive film 4 in the aforementioned embodiment, the present invention is not restricted to this but another inert gas such as He, Ne, Kr or Xe or a gas mixture thereof is also employable.

While transparent conductive films having different peak intensity ratios (I1/I2) were formed by varying oxygen flow rates and strength of magnetic fields applied to the cathode by DC sputtering in the aforementioned embodiment, the present invention is not restricted to this but transparent conductive films having different peak intensity ratios (I1/I2) may alternatively be formed by another method. For example, transparent conductive films having different peak intensity ratios (I1/I2) can also be formed by employing sputtering performed by RF sputtering on DC sputtering or ion plating while setting proper conditions. Also in this case, effects similar to those of the present invention can be attained by forming a transparent conductive film consisting of an ITO film including two (222) peaks. Also in this case, plasma damage against a semiconductor layer serving as the underlayer for the transparent conductive film can be suppressed.

While the present invention is applied to the photovoltaic device having the HIT structure only on the front surface in the aforementioned embodiment, the present invention is not restricted to this but similar effects can be attained also when the present invention is applied to a photovoltaic device having HIT structures on both of the front and back surfaces.

## Claims

1. A photovoltaic device comprising:
a photoelectric conversion layer (1) receiving light incident from the front surface side; and
a transparent conductive film (4), formed on the front surface of said photoelectric conversion layer, including an indium oxide layer having 222, plane orientation with two 222 peaks in said indium oxide layer.

2. The photovoltaic device according to claim 1, further comprising a semiconductor layer, formed thereon with said transparent conductive film, consisting of at least either an amorphous semiconductor or a microcrystalline semiconductor.

3. The photovoltaic device according to claim 1, wherein
said 222 peaks in said indium oxide layer include:
a first peak having an angle 2θ (θ: X-ray diffraction angle) of 30.1 ± 0.1 degrees, and
a second peak having an angle 2θ (θ: X-ray diffraction angle) of 30.6 ± 0.1 degrees.

4. The photovoltaic device according to claim 3, wherein
the ratio (I1/I2) of the intensity (I1) of said first peak to the intensity (I2) of said second peak is at least 0.07 and not more than 0.9.

5. The photovoltaic device according to claim 4, wherein
the ratio (I1/I2) of the intensity (I1) of said first peak to the intensity (I2) of said second peak is at least 0.25 and not more than 0.75.

6. The photovoltaic device according to claim 1, wherein
said indium oxide layer contains Sn.

7. The photovoltaic device according to claim 6, wherein
the content of Sn with respect to In in said indium oxide layer is at least 1 percent by weight and not more than 10 percent by weight.

8. A photovoltaic device comprising:
a first conductivity type crystalline semiconductor substrate (1) having a front surface and a back surface and receiving light incident from the side of said front surface;
a substantially intrinsic first amorphous semiconductor layer (2) formed on said front surface of said crystalline semiconductor substrate;
a second conductivity type second amorphous semiconductor layer (3) formed on said first amorphous semiconductor layer; and
a transparent conductive film (4), formed on said second amorphous semiconductor layer, including an indium oxide layer having 222 plane orientation with two 222 peaks in said indium oxide layer.

9. The photovoltaic device according to claim 8, wherein
said 222 peaks in said indium oxide layer include:
a first peak having an angle 2θ (θ: X-ray diffraction angle) of 30.1 ± 0.1 degrees, and
a second peak having an angle 2θ (θ: X-ray diffraction angle) of 30.6 ± 0.1 degrees.

10. The photovoltaic device according to claim 9, wherein
the ratio (I1/I2) of the intensity (I1) of said first peak to the intensity (I2) of said second peak is at least 0.07 and not more than 0.9.

11. The photovoltaic device according to claim 10, wherein
the ratio (I1/I2) of the intensity (I1) of said first peak to the intensity (I2) of said second peak is at least 0.25 and not more than 0.75.

12. The photovoltaic device according to claim 8, wherein
said indium oxide layer contains Sn.

13. The photovoltaic device according to claim 12, wherein
the content of Sn with respect to In in said indium oxide layer is at least 1 percent by weight and not more than 10 percent by weight.

14. The photovoltaic device according to claim 8, wherein
said crystalline semiconductor substrate is an n-type semiconductor substrate, and said second amorphous semiconductor layer is a p-type semiconductor layer.

15. A device having a transparent conductive film, comprising:
a substrate (1) ; and
a transparent conductive film (4), formed on said substrate, including an indium oxide layer having 222 plane orientation with two 222 peaks in said indium oxide layer.

16. The device having a transparent conductive film according to claim 15, wherein
said 222 peaks in said indium oxide layer include:
a first peak having an angle 2θ (θ: X-ray diffraction angle) of 30.1 ± 0.1 degrees, and
a second peak having an angle 2θ (θ: X-ray diffraction angle) of 30.6 ± 0.1 degrees.

17. The device having a transparent conductive film according to claim 15, wherein
said indium oxide layer contains Sn.

18. The device having a transparent conductive film according to claim 17, wherein
the content of Sn with respect to In in said indium oxide layer is at least 1 percent by weight and not more than 10 percent by weight.

19. A photovoltaic device comprising:
a first conductivity type single-crystalline silicon substrate (1) having a front surface and a back surface and receiving light on the side of said front surface;
a substantially intrinsic first amorphous silicon layer (2) formed on said front surface of said single-crystalline silicon substrate;
a second conductivity type second amorphous silicon layer (3) formed on said first amorphous silicon layer; and
a transparent conductive film (4), formed on said second amorphous silicon layer, including an indium oxide layer having 222 plane orientation with two 222 peaks in said indium oxide layer.

20. The photovoltaic device according to claim 19, wherein
said 222 peaks in said indium oxide layer include:
a first peak having an angle 2θ (θ: X-ray diffraction angle) of 30.1 ± 0.1 degrees, and
a second peak having an angle 2θ (θ: X-ray diffraction angle) of 30.6 ± 0.1 degrees.
